# EUROPEAN PATENT APPLICATION

(11) **EP 3 188 363 A1**
(43) Date of publication of application: **05.07.2017**
(21) Application number: 14881971.7
(22) Date of filing: 11.12.2014
(51) Int. Cl.: H03F 1/07

(54) **POWER AMPLIFIER CIRCUIT AND POWER AMPLIFIER**

(30) Priority: 25.08.2014 CN 201410422449
(71) Applicant: ZTE Corporation, Shenzhen, Guangdong 518057 (CN)
(72) Inventor: YU, Minde, Shenzhen Guangdong 518057 (CN); QIN, Tianyin, Shenzhen Guangdong 518057 (CN); DAI, Li, Shenzhen Guangdong 518057 (CN); FENG, Pingli, Shenzhen Guangdong 518057 (CN)
(74) Representative: Brevalex
(86) International application number: PCT/CN2014/093609
(87) International publication number: WO 2015/117496

(57) **Abstract**

Disclosed is a power amplifier circuit. The circuit comprises: a first amplifier, a first microstrip line connected to an input end of the first amplifier, and a second microstrip line connected to an output end of the first amplifier, wherein the impedance and line width of the second microstrip line can be set according to the output impedance of the power amplifier circuit; and the first amplifier is an amplifier corresponding to an auxiliary power amplifier. Also disclosed is a power amplifier comprising the power amplifier circuit.

## Description

### TECHNICAL FIELD

The disclosure relates to a power amplification technology, and in particular to a power amplifier circuit and a power amplifier.

### BACKGROUND

A large-power broadband base station product has become a competition focus of the industry for increasingly intense competitions at present. Moreover, in a modern wireless communication standard, the large-power broadband base station product adopts a broadband linear modulation mode of a digital modulated signal having a high peak-to-average ratio. Therefore, strict requirements are set on the linearity of a Power Amplifier (PA) applied to the broadband base station product. Furthermore, higher requirements are set on the channel bandwidth of the power amplifier, and a Transformer-Less Load Modulated (TLLM) architecture for a power amplifier circuit structure is an improved structure of a broadband Doherty architecture. It is unnecessary to arrange an impedance transformer at an output end of a power amplifier circuit having the TLLM architecture. Moreover, the power amplifier adopting the TLLM architecture as a circuit structure can implement a wider channel bandwidth, and can reduce the output matching size of the power amplifier, so as to improve the output efficiency of the PA. Therefore, the power amplifier having the TLLM architecture is more and more preferred by people.

However, in a traditional power amplifier circuit having the TLLM architecture, the line width of a microstrip line connected to an auxiliary PA is narrow, and cannot be used for high power data output. Therefore, a novel circuit structure of a power amplifier is urgently needed, so as to solve the above-mentioned problem.

### SUMMARY

In order to solve the existing technical problem, the embodiments of the disclosure provide a power amplifier circuit and a power amplifier, enabling a power amplifier having a TLLM architecture to be used for high power output on the basis of no reduction of advantages of the TLLM architecture.

The technical solution of the embodiments of the disclosure is implemented as follows. The embodiments of the disclosure provide a power amplifier circuit. The circuit may include: a first amplifier, a first microstrip line connected to an input end of the first amplifier, and a second microstrip line connected to an output end of the first amplifier. The impedance and line width of the second microstrip line are set according to the output impedance of the power amplifier circuit; and the first amplifier is an amplifier corresponding to an auxiliary power amplifier.

In the above-mentioned solution, the circuit may further include: a second amplifier, a third microstrip line connected to an input end of the second amplifier, and a fourth microstrip line connected to an output end of the second amplifier.

In the above-mentioned solution, the circuit may further include: a first quarter wavelength transmission line and a second quarter wavelength transmission line. The first quarter wavelength transmission line is located at the input end of the first amplifier, and is connected to the first microstrip line; and the second quarter wavelength transmission line is located at the output end of the second amplifier, and is connected to the fourth microstrip line.

In the above-mentioned solution, the first amplifier, the first microstrip line, the second microstrip line and the first quarter wavelength transmission line may be connected in series to form a first branch circuit; and the second amplifier, the third microstrip line, the fourth microstrip line and the second quarter wavelength transmission line may be connected in series to form a second branch circuit, and the first branch circuit and the second branch circuit may be connected in parallel.

The embodiments of the disclosure also disclose a power amplifier. A circuit of the power amplifier may include: a first amplifier, a first microstrip line connected to an input end of the first amplifier, and a second microstrip line connected to an output end of the first amplifier. The impedance and line width of the second microstrip line are set according to the output impedance of the power amplifier circuit; and the first amplifier is an amplifier corresponding to an auxiliary power amplifier.

In the above-mentioned solution, the circuit of the power amplifier may further include: a second amplifier, a third microstrip line connected to an input end of the second amplifier, and a fourth microstrip line connected to an output end of the second amplifier.

In the above-mentioned solution, the circuit of the power amplifier may further include: a first quarter wavelength transmission line and a second quarter wavelength transmission line. The first quarter wavelength transmission line is located at the input end of the first amplifier, and is connected to the first microstrip line; and the second quarter wavelength transmission line is located at the output end of the second amplifier, and is connected to the fourth microstrip line.

In the above-mentioned solution, the first amplifier, the first microstrip line, the second microstrip line and the first quarter wavelength transmission line in the circuit of the power amplifier may be connected in series to form a first branch circuit; and the second amplifier, the third microstrip line, the fourth microstrip line and the second quarter wavelength transmission line may be connected in series to form a second branch circuit, and the first branch circuit and the second branch circuit may be connected in parallel.

In the power amplifier circuit and the power amplifier provided in the embodiments of the disclosure, the impedance of the second microstrip line connected to the output end of the first amplifier can be set according to the output impedance of the power amplifier circuit, and the minimum line width of the second microstrip line is determined according to the load impedance and matching impedance of the first branch circuit where the first amplifier is located, as well as the impedance of the second microstrip line. Thus, the second microstrip line can satisfy conditions of the power amplifier used in the embodiments of the disclosure under a small power working state, and can also satisfy conditions of the power amplifier used in the embodiments of the disclosure under a high power working state. Moreover, since the second microstrip line can be self-set according to practical application situations, the efficiency of the power amplifier can be improved when the heat loss of the power amplifier is low and the second microstrip line is not burnt down, so as to implement the high power output of the power amplifier. Besides, the structure of the power amplifier circuit in the embodiments of the disclosure is an improved TLLM framework structure. Therefore, the embodiments of the disclosure enable a power amplifier having a TLLM architecture to be used for high power output on the basis of no reduction of advantages of the TLLM architecture.

### BRIEF DESCRIPTION OF THE DRAWINGS

Fig. 1 is a circuit structure diagram of a power amplifier having a traditional TLLM framework;
Fig. 2 is a structure diagram of a power amplifier circuit according to an embodiment of the disclosure;
Fig. 3 is a specific implementation structure diagram of a power amplifier circuit according to an embodiment of the disclosure;
Fig. 4 is a specific circuit structure diagram of a power amplifier having a traditional TLLM framework;
Fig. 5 is a specific circuit structure diagram 1 of a power amplifier circuit according to an embodiment of the disclosure;
Fig. 6 is a specific circuit structure diagram 2 of a power amplifier circuit according to an embodiment of the disclosure;
Fig. 7 is a specific circuit structure diagram 3 of a power amplifier circuit according to an embodiment of the disclosure; and
Fig. 8 is a specific circuit structure diagram 4 of a power amplifier circuit according to an embodiment of the disclosure.

### DETAILED DESCRIPTION

In order to be capable of knowing the characteristics and technical contents of the embodiments of the disclosure in more detail, implementation of the embodiments of the disclosure will be elaborated below with the drawings. The appended drawings are only used for reference, and not intended to limit the disclosure.

A traditional TLLM architecture applied to a power amplifier circuit includes two power amplifiers: a main power amplifier and an auxiliary power amplifier. The main power amplifier works in a class B or class AB, and the auxiliary power amplifier works in a class C. Matching of power points of the two power amplifiers can obtain 100ohm, matching of efficiency points can obtain 50ohm, and an output combining end directly adopts a microstrip line of 50ohm for output.

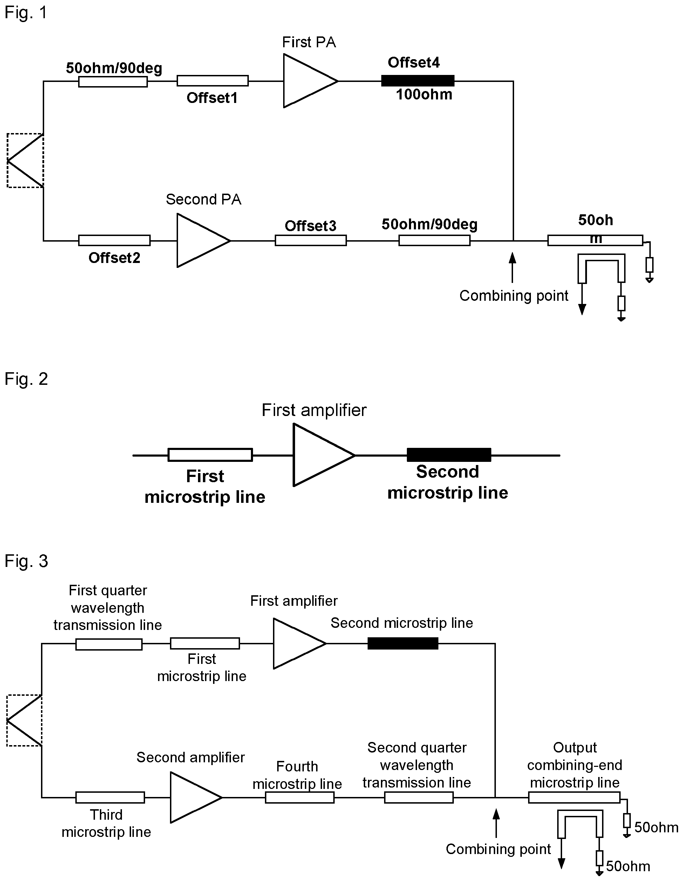

As shown in Fig. 1, a first power amplifier is the auxiliary power amplifier, and a second power amplifier is the main power amplifier. An output end of the auxiliary power amplifier is connected to a microstrip line of which the impedance is 100ohm and the line width is 0.3mm. Since both a metal conductor strip of the microstrip line and a grounding plate have high-frequency surface current during high power output, heat loss exists. Since the line width of the microstrip line is in direct proportion to the heat loss, a power amplifier having the traditional TLLM architecture will have a large heat loss inevitably during high power output due to narrow line width. Moreover, the own temperature of the microstrip line will rise up inevitably due to the heat loss, to cause reduction of the efficiency of the power amplifier. Therefore, a risk of burnout caused by over-high own temperature of the microstrip line exists. On the basis of this, the power amplifier having the traditional TLLM architecture cannot be used for high power output. In order to solve the above-mentioned problems, the embodiments of the disclosure provide an improved power amplifier circuit structure. The embodiments of the disclosure will be further described in detail below with the drawings.

Fig. 2 is a structure diagram of a power amplifier circuit according to an embodiment of the disclosure. As shown in Fig. 2, the power amplifier circuit includes: a first amplifier, a first microstrip line connected to an input end of the first amplifier, and a second microstrip line connected to an output end of the first amplifier. The impedance and line width of the second microstrip line are set according to the output impedance of the power amplifier circuit; and the first amplifier is an amplifier corresponding to an auxiliary power amplifier.

Specifically, the impedance of the second microstrip line can be set according to the output impedance of the power amplifier circuit and a matching circuit; the line width of the second microstrip line can be set according to the load impedance and matching impedance of a first branch circuit where the first amplifier is located, as well as the impedance of the second microstrip line; it is important to note that the second microstrip line may be composed of N microstrip lines, each microstrip line having own characteristic impedance and line width; and when the second microstrip line is composed of N microstrip lines, the line width of the second microstrip line is narrowest among the line widths of the N microstrip lines, where N is a positive integer greater than or equal to 1.

Referring to Fig. 3, on the basis of the solution shown in Fig. 2, the power amplifier circuit further includes: a second amplifier, a third microstrip line connected to an input end of the second amplifier, and a fourth microstrip line connected to an output end of the second amplifier.

In the above-mentioned solution, the power amplifier circuit further includes: a first quarter wavelength transmission line and a second quarter wavelength transmission line. The first quarter wavelength transmission line is located at the input end of the first amplifier, and is connected to the first microstrip line; and the second quarter wavelength transmission line is located at the output end of the second amplifier, and is connected to the fourth microstrip line.

In the above-mentioned solution, the first amplifier, the first microstrip line, the second microstrip line and the first quarter wavelength transmission line are connected in series to form a first branch circuit; and
the second amplifier, the third microstrip line, the fourth microstrip line and the second quarter wavelength transmission line are connected in series to form a second branch circuit, and the first branch circuit and the second branch circuit are connected in parallel.

From comparison between a circuit structure shown in Fig. 3 and a circuit structure shown in Fig. 1, it may be seen that a microstrip line of which the impedance is 100ohm and the line width is 0.3mm in the circuit structure shown in Fig. 3 is replaced with a second microstrip line randomly disposed according to the output impedance. Moreover, the second microstrip line can achieve the effect of matching a first branch circuit when a first amplifier is in a high power working state. That is, when the power amplifier circuit is in a high power working state, the second microstrip line and a matching circuit can achieve the effect of matching the first branch circuit. When the first amplifier is in an off state, the impedance of the first branch circuit is pulled to infinity. That is, when the power amplifier circuit is in a small power working state, the second microstrip line and the matching circuit can pull the matching impedance of the first branch circuit to infinity. Thus, the effects of impedance matching and off impedance of the first branch circuit where the first amplifier is located can be achieved simultaneously by using the second microstrip line, so the power amplifier having the circuit structure shown in Fig. 3 can play the advantages of high-efficiency and small-size broadband of the TLLM architecture. Moreover, since the impedance and line width of the second microstrip line in Fig. 3 can be set according to the output impedance of the power amplifier circuit, the power amplifier having the circuit structure shown in Fig. 3 is enabled to be used for high power output on the basis of no reduction of advantages of the TLLM architecture.

In practical application, firstly, the output load impedance of the first branch circuit where the first amplifier is located as well as the matching impedance of the first branch circuit are determined, and the matching impedance of the first amplifier includes output saturation power point impedance and off impedance. Secondly, the minimum line width and impedance of the second microstrip line connected to the output end of the first amplifier are determined according to the output current of the first branch circuit. Finally, an output matching circuit of the first branch circuit is determined according to the output load impedance and matching impedance of the first branch circuit where the first amplifier is located as well as the minimum line width of the second microstrip line, such that the first branch circuit can satisfy large signal saturation output power point impedance as well as small signal off impedance during output matching of the first branch circuit.

It is important to note that in practical application, the setting sequence of the minimum line width and impedance of the second microstrip line and the matching circuit is not limited to the above-mentioned situation. The matching circuit may be preset, and then the minimum line width and impedance of the second microstrip line are determined according to the matching circuit. However, any sequence is intended to enable the line width and impedance of the second microstrip line to satisfy a specific practical application situation, such that the structure of the power amplifier circuit in the embodiments of the disclosure enables the power amplifier having the TLLM architecture to be used for high power output without reduction of advantages of the TLLM architecture.

The disclosure will be further described in detail below with specific embodiments.

Specifically, as shown in Fig. 1, the first amplifier works in a class C, and the second amplifier works in a class AB. The whole power amplifier is in a small signal working state, i.e., in a 0.25Pomax working state. At this time, since the first amplifier works in a class C, under a small signal working state, the first amplifier does not work, an open circuit state is presented from a combining point to a micro-point line 4 (offset4), i.e., an impedance infinity state. At this time, only the second amplifier in the whole power amplifier circuit works. When the preset output impedance is 50ohm, i.e., the output impedance of a combining point is 50ohm, the load impedance of the second amplifier is 50ohm. The whole power amplifier is in a large signal working state, i.e., in a saturation (Pomax) working state. At this time, with the increase of input power, the first amplifier is in an open state, so as to reach a saturation power point finally. When the preset output impedance is 50ohm, i.e., the output impedance of the combining point is 50ohm, the impedance of matching between the first branch circuit where the first amplifier is located and the second branch circuit where the second amplifier is located is 100ohm.

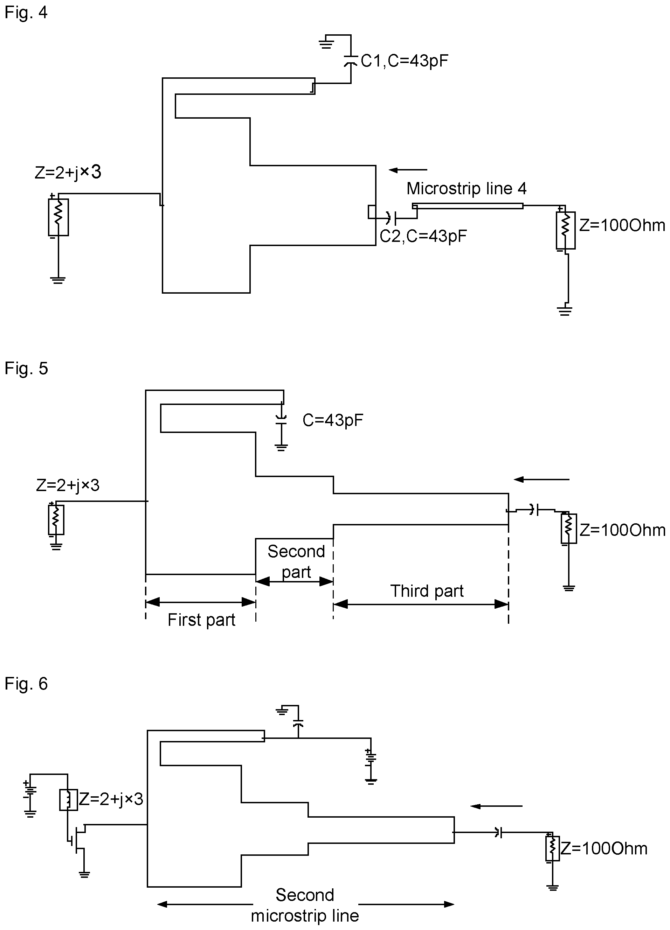

Fig. 4 is a specific circuit structure diagram of a power amplifier having a traditional TLLM framework. For example, the output frequency is 900 MHz. At this time, the whole power amplifier is in a high power working state. As shown in Fig. 4, the preset target matching impedance is Z=2+j3, where the 2+j3 represents an impedance point, that is, the impedance is matched to the 2+j3, the impedance value is 2+j3, and j may be determined according to a microstrip line structure. In order to adapt the circuit structure shown in Fig. 4 to the off state of the power amplifier, it is necessary to arrange a microstrip line 4. The impedance of the microstrip line 4 is 100ohm, the line width is 0.3mm, and the matching circuit structure shown in Fig. 4 is determined according to the target matching impedance and the impedance and line width of the microstrip line 4. At this time, since the power of the circuit is large and the line width of the microstrip line 4 of 100ohm is narrow, the heat loss of the microstrip line 4 is large, and the temperature rises up greatly. Therefore, the efficiency of a power amplifier will be reduced inevitably, and a risk of burnout caused by over-high temperature rise of the microstrip line 4 exists.

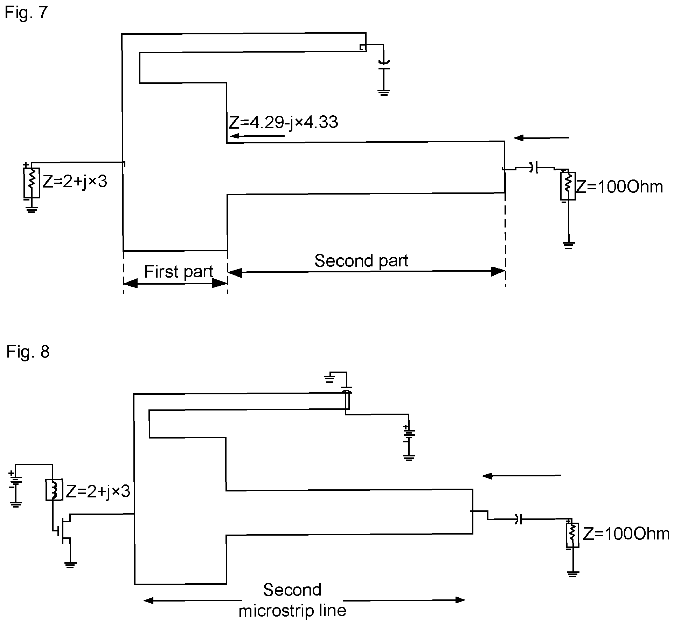

In order to improve the existing TLLM framework shown in Fig. 4, the embodiments of the disclosure provide a novel power amplifier circuit. Fig. 5 is a specific circuit structure diagram 1 of a power amplifier circuit according to an embodiment of the disclosure; Fig. 6 is a specific circuit structure diagram 2 of a power amplifier circuit according to an embodiment of the disclosure; Fig. 7 is a specific circuit structure diagram 3 of a power amplifier circuit according to an embodiment of the disclosure; and Fig. 8 is a specific circuit structure diagram 4 of a power amplifier circuit according to an embodiment of the disclosure.

Likewise, it is supposed that the output frequency is 900 MHz. At this time, the whole power amplifier is in a high power working state. As shown in Fig. 5, the power amplifier is in a high power working state, the preset target matching impedance is Z=2+j3, the impedance and line width of the second microstrip line are determined according to the target matching impedance and the load impedance of the first amplifier, and the matching circuit structure shown in Fig. 5 is further determined. If the output impedance of the combining point is 50ohm, the output impedance of the circuit shown in Fig. 5 shall be 100ohm. At this time, since the target matching impedance point is 2+jx3, the impedance output via first, second and third parts of the second microstrip line is 100ohm, and the first part, the second part and the third part are microstrip lines having specific impedance and specific line width. Further, when the power amplifier circuit is in a small power working state, the matching circuit structure is as shown in Fig. 6. At this time, the impedance of the first branch circuit where the first amplifier is located is pulled to infinity by means of the matching circuit.

The working principles of Fig. 7 and Fig. 8 are similar to those of Fig. 5 and Fig. 6. Only the second microstrip line is arranged in the first amplifier in the circuit structures shown in Fig. 6 and Fig. 7.

Specifically, it is supposed that the output frequency is 900 MHz. At this time, the whole power amplifier is in a high power working state. As shown in Fig. 7, the power amplifier is in a high power working state, the preset target matching impedance is Z=2+j3, the impedance and line width of the second microstrip line are determined according to the target matching impedance and the load impedance of the first amplifier, and the matching circuit structure shown in Fig. 5 is further determined. If the output impedance of the combining point is 50ohm, the output impedance of the circuit shown in Fig. 7 shall be 100ohm. At this time, if a microwave panel of which a dielectric constant is 9.6 is adopted, since the target matching impedance point is 2+jx3, the impedance is matched to 4.29-j*4.33ohm via a first part of the second microstrip line, i.e., a microstrip line of which the line width is 28.6mm, the length is 5.14mm and the feature impedance is 3ohm; and then, the impedance is matched to 100ohm via a second part, i.e., a microstrip line of which the line width is 3.11 mm, the length is 25.84mm and the feature impedance is 20ohm, thereby achieving the aim that the output impedance is 100ohm. Further, Further, when the power amplifier circuit is in a small power working state, the matching circuit structure is as shown in Fig. 8. At this time, the impedance of the first branch circuit where the first amplifier is located is pulled to infinity by means of the matching circuit.

It is important to note that only the first amplifier, the microstrip line connected to the output end of the first amplifier and the specific structure of the matching circuit are provided in the circuit structure shown in Fig. 4 to Fig. 8. Other components in the structure of the power amplifier circuit are not shown. Besides, the line width and impedance of the second microstrip line may be randomly set according to the matching circuit, as long as the preset output impedance can be obtained according to the matching circuit and the second microstrip line.

When the circuit in the embodiments of the disclosure is in a high power state, the matching circuit is regulated to enable the circuit in the embodiments of the disclosure to obtain target impedance by matching after the line width of the second microstrip line is increased, so as to implement high power working. Therefore, by means of the power amplifier circuit in the embodiments of the disclosure, the power amplifier is enabled to be used for high power output without reduction of the advantages of the TLLM architecture.

The embodiments of the disclosure also provide a power amplifier. A circuit of the power amplifier includes: a first amplifier, a first microstrip line connected to an input end of the first amplifier, and a second microstrip line connected to an output end of the first amplifier. The impedance and line width of the second microstrip line are set according to the output impedance of the power amplifier circuit; and the first amplifier is an amplifier corresponding to an auxiliary power amplifier.

In the above-mentioned solution, the circuit of the power amplifier further includes: a second amplifier, a third microstrip line connected to an input end of the second amplifier, and a fourth microstrip line connected to an output end of the second amplifier.

In the above-mentioned solution, the circuit of the power amplifier further includes: a first quarter wavelength transmission line and a second quarter wavelength transmission line. The first quarter wavelength transmission line is located at the input end of the first amplifier, and is connected to the first microstrip line; and the second quarter wavelength transmission line is located at the output end of the second amplifier, and is connected to the fourth microstrip line.

In the above-mentioned solution, the first amplifier, the first microstrip line, the second microstrip line and the first quarter wavelength transmission line in the circuit of the power amplifier are connected in series to form a first branch circuit; and the second amplifier, the third microstrip line, the fourth microstrip line and the second quarter wavelength transmission line are connected in series to form a second branch circuit, and the first branch circuit and the second branch circuit are connected in parallel.

The above is only preferred implementation modes of the embodiments of the disclosure. It should be pointed out that those of ordinary skill in the art may also make some improvements and modifications without departing from the principle of the embodiments of the disclosure. These improvements and modifications should fall within the scope of protection of the embodiments of the disclosure.

### INDUSTRIAL APPLICABILITY

In the embodiments of the disclosure, the impedance of the second microstrip line connected to the output end of the first amplifier can be set according to the output impedance of the power amplifier circuit, and the minimum line width of the second microstrip line is determined according to the load impedance and matching impedance of the first branch circuit where the first amplifier is located, as well as the impedance of the second microstrip line. Thus, the second microstrip line can satisfy conditions of the power amplifier used in the embodiments of the disclosure under a small power working state, and can also satisfy conditions of the power amplifier used in the embodiments of the disclosure under a high power working state. Moreover, since the second microstrip line can be self-set according to practical application situations, the efficiency of the power amplifier can be improved when the heat loss of the power amplifier is low and the second microstrip line is not burnt down, so as to implement the high power output of the power amplifier. Besides, the structure of the power amplifier circuit in the embodiments of the disclosure is an improved TLLM framework structure. Therefore, the embodiments of the disclosure enable a power amplifier having a TLLM architecture to be used for high power output on the basis of no reduction of advantages of the TLLM architecture.

## Claims

1. A power amplifier circuit, comprising: a first amplifier, a first microstrip line connected to an input end of the first amplifier, and a second microstrip line connected to an output end of the first amplifier, wherein
an impedance and line width of the second microstrip line are set according to an output impedance of the power amplifier circuit; and
the first amplifier is an amplifier corresponding to an auxiliary power amplifier.

2. The circuit according to claim 1, further comprising: a second amplifier, a third microstrip line connected to an input end of the second amplifier, and a fourth microstrip line connected to an output end of the second amplifier.

3. The circuit according to claim 2, further comprising: a first quarter wavelength transmission line and a second quarter wavelength transmission line,
wherein the first quarter wavelength transmission line is located at the input end of the first amplifier, and is connected to the first microstrip line; and
the second quarter wavelength transmission line is located at the output end of the second amplifier, and is connected to the fourth microstrip line.

4. The circuit according to claim 3, wherein the first amplifier, the first microstrip line, the second microstrip line and the first quarter wavelength transmission line are connected in series to form a first branch circuit; and
the second amplifier, the third microstrip line, the fourth microstrip line and the second quarter wavelength transmission line are connected in series to form a second branch circuit, and the first branch circuit and the second branch circuit are connected in parallel.

5. A power amplifier, a circuit of the power amplifier comprising: a first amplifier, a first microstrip line connected to an input end of the first amplifier, and a second microstrip line connected to an output end of the first amplifier, wherein
an impedance and line width of the second microstrip line are set according to an output impedance of the power amplifier circuit; and
the first amplifier is an amplifier corresponding to an auxiliary power amplifier.

6. The power amplifier according to claim 5, wherein the circuit of the power amplifier further comprises: a second amplifier, a third microstrip line connected to an input end of the second amplifier, and a fourth microstrip line connected to an output end of the second amplifier.

7. The power amplifier according to claim 6, wherein the circuit of the power amplifier further comprises: a first quarter wavelength transmission line and a second quarter wavelength transmission line,
wherein the first quarter wavelength transmission line is located at the input end of the first amplifier, and is connected to the first microstrip line; and
the second quarter wavelength transmission line is located at the output end of the second amplifier, and is connected to the fourth microstrip line.

8. The power amplifier according to claim 7, wherein the first amplifier, the first microstrip line, the second microstrip line and the first quarter wavelength transmission line in the circuit of the power amplifier are connected in series to form a first branch circuit; and
the second amplifier, the third microstrip line, the fourth microstrip line and the second quarter wavelength transmission line are connected in series to form a second branch circuit, and the first branch circuit and the second branch circuit are connected in parallel.
